Europäisches Patentamt

European Patent Office

Office européen des brevets

(11) Publication number: **0 211 760**
**A1**

(12) **EUROPEAN PATENT APPLICATION**

(21) Application number: **86401713.2**

(22) Date of filing: **31.07.86**

(51) Int. Cl.⁴: **H 01 R 43/22**
**H 05 K 13/04**

(30) Priority: **02.08.85 FR 8511876**

(43) Date of publication of application:
**25.02.87 Bulletin 87/9**

(84) Designated Contracting States:
**BE CH DE FR GB IT LI NL SE**

(71) Applicant: THOMAS & BETTS CORPORATION
920 Route 202
Raritan New Jersey 08869(US)

(72) Inventor: Gobert, Bernard
60 rue des Chesneaux
F-85160 Montmorency(FR)

(74) Representative: Picard, Jean-Claude Georges et al,
Cabinet Plasseraud 84, rue d'Amsterdam
F-75009 Paris(FR)

(54) **Contact element dispenser.**

(57) A dispenser for applying contact elements onto pins of a printed circuit board comprises a U-shaped slide for slidingly receiving a series of contact elements therein. A slider is retained in the slide for engagement with thr innermost contact elements so as to apply a force thereto for dispensing contact elements. The outermost contact elements cooperate with resilient stop means projecting inwardly from the side walls of the slide to resiliently detain the outermost contact element and thereby the entire series of elements in the slide. The slide is preferably formed to dispesne contct elements from both ends thereof, the slider being located substantially centrally of the slide.

EP 0 211 760 A1

./...

FIG.1

## CONTACT ELEMENT DISPENSER

FIELD OF THE INVENTION:

The present invention relates to a contact element dispenser and more especially to a dispenser for laying elements individually on cooperating pieces fixed to a support.

BACKGROUND OF THE INVENTION:

The elements may, for example, include shunt jumpers intended to be inserted on pairs of pins carried by an insulative support for short circuiting. Such jumpers are often of very small size, of the order of a few millimeters, and are difficult to handle. Laying a large number of such elements which are usually gripped between two fingers proves tiring and time consuming.

SUMMARY OF THE INVENTION:

An object of the present invention is to provide a dispenser for such contact elements which would make the laying of these elements on cooperating pieces fixed to a support easier and faster when there is a large number of elements to lay.

In accordance with the invention, a dispenser of the above mentioned type comprises a slide with side walls adapted for slidingly receiving, through at least one of its ends which is open, a series of contact elements, which series is ended at one end by an outer element and at the other end by an inner element. A slider is retained in the slide and is adapted for sliding therein so as to be able to exert a thrust on the inner element and thereby on the series of elements placed in the slide. The slider has for this purpose, above the side walls of the slide, a projecting portion actuatable by a finger of the user. A resilient stop means is provided at the end of the slide and adapted for cooperating with the outer element of the series, for retaining it in the slide.

With such an apparatus, it will be readily understood that, by exerting a thrust for example with the thumb on the slider, the contact elements may be extracted from the slide as they are needed and may be immediately laid on the cooperating pieces, without having to grip said elements. The prior operation of gripping each of the elements between two fingers, which operation was delicate, is replaced by a much more convenient operation, which includes taking the slide in the hand, in directing its end toward the cooperating pieces (for example two pins to be short circuited), then in pushing the outer element outside of the slide onto the pins, by a thrust action exerted on the slider, this action being sufficiently strong to overcome the locking effect of said resilient stop means.

Preferably, the slide may further have two open ends and be adapted for slidingly receiving a series of contact elements through each of its ends, the two series being positioned on each side of said slider, resilient stop means being provided at both ends of the slider, for cooperating with the respective outer endmost elements of the series of elements.

Thus, when the series of contact elements disposed on one side of the slider is exhausted, the series which extends on the other side may then be used, the slider then being moved in the opposite direction.

The resileint stop means may be formed simply, for example, by means of two facing projections, at the end of the slide, on the inner side walls thereof, these projections being adapted for snap fitting respectively into grooves formed in the two opposite side faces of the contact elements.

The resilience of the stop means thus obtained may be provided by spacing the two side walls of the slide relatively slightly apart, this slide being, for example, made from metal or a plastic material.

It may further be provided, also in a very simple manner, for the side walls of the slide to be slightly drawn together towards their free edge, so as to retain said contact elements as well as the slider, this construction having for this purpose a base which, with respect to the projecting part, is laterally widened.

Thus, the slider is captivated in the slide and the element can only escape therefrom through one or other of the open ends thereof.

The present invention further relates to an assembly of dispensers of the above defined type, such an assembly being characterized in that it comprises several dispensers disposed parallel to each other, each furnished with a series of contact elements, and in that the outer elements of each series are integral with a strip, to which they are each connected to a pre-break line.

It will be readily understood that this strip, by way of the outer elements, will allow a certain number of dispensers to be joined together, especially if, as is preferable, this type of joining by strips is provided at both ends thereof.

The strips may be molded in a single piece with the synthetic material bodies of a certain number of contact elements and which serve for joining them together in the form of a cluster, as is well known when it is desired to handle synthetic material pieces of small sizes.

These strips may further be used for introducing the contact elements in a single operation into a number of dispensers, the successively used strips being broken progressively so that the elements which are then detached therefrom may be introduced into their respective slides, only the strips of the last elements introduced, namely the outer elements, not being broken so as to allow several dispensers to be joined together, as indicated above.

One embodiment of the invention wil now be described, by way of a non-limitative example, with reference to the Figures of the accompanying drawings.

BRIEF DESCRIPTION OF THE DRAWINGS:

Figure 1 is a perspective view of a dispenser in accordance with the invention;

Figure 2 shows in perspective an assembly of dispensers according to the invention;

Figure 3 shows in perspective a method of using the dispenser of Figure 1; and

Figure 4 is a cross-sectional view of a dispenser through line IV-IV of Figure 1.

DESCRIPTION OF THE PREFERRED EMBODIMENT:

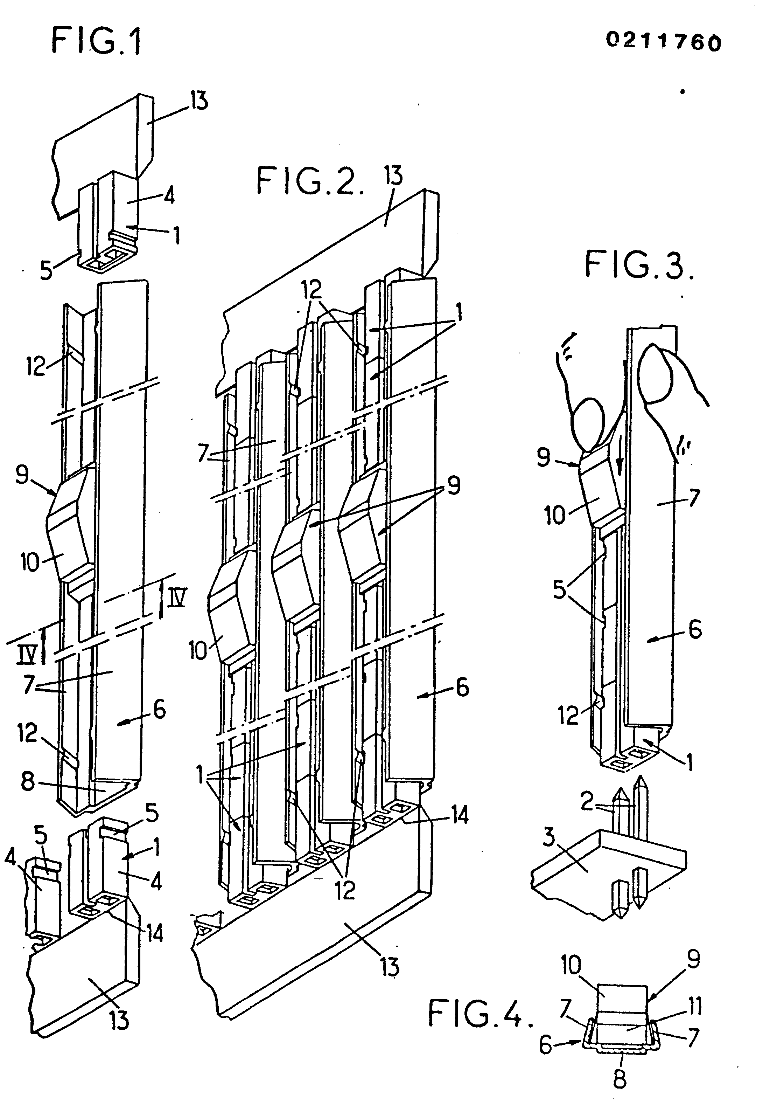

In Figures 1 to 3, the contact elements are designated generally by reference numeral 1. They may be jumpers made from an insulating material, more especially from a synthetic material, including a clip made from an electrically conducting material (not shown in the Figures). This clip is intended, for example when element 1 inserted on two contact pins 2, such as those which have been shown in Figure 3 and which are fixed to a support 3 (for example a printed circuit card), to short circuit these two pins.

These pins 2 form the cooperating pieces.

Contact elements 1 have two opposite side faces 4 comprising, respectively, two opposite grooves 5.

Regarding the dispenser, it comprises a slide 6 with a generally U-cross section, having side walls 7 and a bottom 8, and which slide is open at both ends thereof. This slide 6 may be made from metal or a synthetic material.

In slide 6 is slidingly mounted a slider 9 having a projecting part 10 actuatable, in opposite directions, by a finger of the user (see Figure 3). With respect to this projecting part, base 11 of slider 9 is laterally widened (see Figure 4), so that the slider is captivated in the slide 6. The two side walls 7 are drawn slightly together towards their free ends.

At both its ends, each slide 6 is provided with resilient stop means formed, for each end, by two facing projections 12 on the side wall 7 of the slide. These two projections cooperate, by resilient snap fitting, with the two above mentioned grooves 5 of the contact elements, the resilience of the snap fit provided mainly by a flexure of walls 7.

Thus, the outer contact elements 1 may be retained in slide 6 and may retain therein all the other elements 1 of the series of elements which are included between this outer element and slider 9. When the slide of a dispenser has been fully furnished with contact elements, a simple thrust with the thumb exerted on the projecting part 10 of the slider in the direction of the arrow, as shown in Figure 3, will then allow the series of elements 1 to be advanced, the base 11 of the slider pushing against the inner element 1. The outer element 1 may then be removed from the slide after resilient retraction of the side projections 12 and be fitted onto the pins 2 to be short circuited, for example. This operation may be repeated in the same way until the series of elements has been exhausted, after which the slide may be turned around and the slider 9 moved in the opposite direction for use in the same way the series of elements 1 were diposed from the other side.

- Figures 1 and 2 show that the contact elements 1 may be introduced into the slides, at both their ends, by using strips 13 joining together a certain number of contact elements 1, the same number of slides preferably being furnished at the same time. The contact elements 1

0211760

AE-270

are joined to bars 13 by pre-break lines 14 along which they may be easily broken.

After breaking strips 13, a new row of contact elements may thus be introduced into the assembly of slides, and so on until all the slides 6 are full.

Only the strips 13 on which the outer contact elements 1 are mounted will not be broken, which, as was mentioned above, will join the set of slides together for transport or storage thereof (Figure 2).

The user will then only have to break these strips so as to be able to use all the dispensers of the assembly, in the manner described above.

As is evident and as it follows from the description herein, the invention is illustrative and not limited to those embodiments which have been more particularly described. As such, the invention embraces all variants thereof. The true scope of the invention is set forth in the appended claims.

**0211760**

CLAIMS:

1. A dispenser of contact elements (1), for laying such elements (1) individually on cooperating pieces (2) fixed to a support (3), these contact elements (1) having two opposite side faces (4), the dispenser comprising: a slide (6) having side walls (7) adapted for slidingly receiving, through at least one of its ends which is open, a series of said contact elements (1); an outer element and at the other end in an inner element; a slider (9) retained in the slide (6) and adapted for sliding therein so as to be able to exert a thrust on said inner element and thereby on the whole series of elements in the slide, said slider (9) having a projecting portion (10) actuatable by a finger of the user; and resilient stop means provided at said end of the slide (6) and adapted for cooperating with the outer element of said series, for retaining said outer element in the slide (6).

2. A dispenser according to claim 1, wherein said slide (6) has two open ends and is adapted for slidingly receiving a series of contact elements (1) through each of its ends, the two series being positioned on each side of said slider (9), and wherein resilient stop means is provided at each end of the slide (6) for cooperating with the respective outer elements of said series of elements (1).

3. A dispenser according to claim 1 or 2, wherein said resilient stop means is formed by two facing projections (12), adjacent an end of the slide (6), on the side walls (7) thereof, these projections (12) being adapted for resiliently and respectively snap fitting in grooves (5) formed in said two opposite side faces (4) of the contact elements (1).

4. A dispenser according to claim 3, wherein said side walls (7) of the slider (6) are drawn slightly together towards their free end, so as to retain said contact

0211760
AE-270

elements (1) and said slider (9), said slider (9) having a base (11) which, with respect to said projecting part (10), is laterally widened.

5. A set of dispensers according to claims 1 or 2, comprising plural such dispensers disposed parallel to each other, each furnished with a series of contact elements (1), and wherein the outer elements of each series are joined together by a strip (13), to which they are each connected by a pre-break line (14).

FIG.1

FIG.2.

FIG.3.

FIG.4.

0211760

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| X | US-A-4 131 982 (ROSE) <br> * Column 1, line 32 - column 2, line 22; column 3, line 48 - column 4, line 6; figures 3,4 * | 1,3 | H 01 R 43/22 <br> H 05 K 13/04 |
| A | | 2 | |
| A | US-A-4 077 117 (GAVIN) <br> * Column 3, line 4 - column 4, line 11; figures 8-12 * | 1 | |
| A,P | EP-A-0 164 481 (NORDIN) <br> * Page 5, lines 1-20; figure 3 * | 1,3 | |

**TECHNICAL FIELDS SEARCHED (Int. Cl.4)**

H 01 R 31/08
H 05 K 13/04
H 01 R 43/22
A 61 C 5/08

The present search report has been drawn up for all claims

| Place of search | Date of completion of the search | Examiner |
|---|---|---|
| THE HAGUE | 10-11-1986 | CRIQUI J.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82